Europäisches Patentamt

European Patent Office

Office européen des brevets

(19)

(11) **EP 1 128 292 A1**

(12) # DEMANDE DE BREVET EUROPEEN

(43) Date de publication:
**29.08.2001 Bulletin 2001/35**

(51) Int Cl.7: **G06F 17/50**

(21) Numéro de dépôt: **01109830.8**

(22) Date de dépôt: **22.01.1998**

(84) Etats contractants désignés:
**DE FR GB IT**

(62) Numéro(s) de document de la (des) demande(s) initiale(s) en application de l'article 76 CBE:
**98400134.7 / 0 932 110**

(71) Demandeur: **BULL S.A.**
**78430 Louveciennes (FR)**

(72) Inventeur: **Thill, Michel**
**78340 Les Clayes sous Bois (FR)**

(74) Mandataire: **Denis, Hervé et al**
**BULL S.A.**
**PC 58D20,**
**68, route de Versailles**
**78434 Louveciennes Cedex (FR)**

Remarques:
Cette demande a été déposée le 21 - 04 - 2001 comme demande divisionnaire de la demande mentionnée sous le code INID 62.

(54) **Procédé d'évaluation d'aptitude d'un circuit à très haute intégration à résister aux bruits diaphonie**

(57) Le procédé comprend une étape (E6) de recherche d'une tranche de temps de cycle d'horloge pour chaque conducteur du circuit, dans laquelle un plus grand nombre d'intervalles temporels de commutation se produisent sur des conducteurs ayant une capacité de couplage avec le conducteur considéré, et une étape (E9) de détermination d'aptitude d'un récepteur, branché en aval du conducteur, à résister au bruit de diaphonie provoqué par les conducteurs sur le conducteur considéré dans ladite tranche de temps.

Fig.9

EP 1 128 292 A1

**Description**

Le domaine de l'invention est celui de l'analyse de performance de circuits électriques. Les composantes de l'analyse de performance considérées dans le cadre de l'invention sont plus particulièrement la détermination de la vitesse à laquelle un circuit, ou un élément de circuit, peut générer des signaux de sortie à partir de signaux d'entrée. L'invention a pour objet un procédé d'évaluation d'aptitude d'un circuit à très haute intégration à résister aux bruits de diaphonie.

Un circuit de traitement numérique est habituellement constitué de bascules mémorisant un état stable de signaux et de portes logiques reliant ces bascules au moyen de conducteurs électriques, de façon à réaliser des combinaisons logiques de ces signaux. Des fronts d'horloges provoquent l'émission de ces signaux en sortie de bascules et leur réception en entrée d'autres bascules. Suite à l'émission de signaux en sortie de bascules sur un front d'horloge, il est nécessaire que les entrées des autres bascules en aval aient commuté sur un état stable avant le front suivant d'horloge. L'instant de commutation sur l'entrée d'une autre bascule dépend de la vitesse à laquelle se propagent les signaux à travers les portes logiques et sur les conducteurs qui les relient entre elles et aux bascules. Cette vitesse, et donc l'instant de commutation, dépend du temps de commutation propre à chaque porte et des caractéristiques d'impédance des conducteurs: résistance, inductance et capacité. La connaissance de l'instant de commutation le plus tardif suite à un front d'horloge permet de déterminer la plus courte période d'horloge admissible par le circuit. Si la période d'horloge est imposée et que la durée qui sépare un front d'horloge de l'instant de commutation en entrée d'une bascule est supérieure à une période d'horloge, il est nécessaire de modifier la structure du circuit de façon à réduire cette durée en deçà de la période d'horloge.

Quand bien même les signaux circulent-ils et se combinent-ils rapidement d'une bascule de mémorisation à l'autre, il convient que les valeurs obtenues soient le moins erronées possible. Une source d'erreur importante est la sensibilité au bruit des éléments du circuit. Il est intéressant d'évaluer la sensibilité du circuit au bruit de façon à le redimensionner si besoin est, pour accroître son immunité ou simplement à s'assurer de cette immunité. L'immunité d'un élément de circuit est définie comme étant une variation de tension d'état stable en entrée qui ne provoque aucune variation de tension en sortie de cet élément. L'immunité est liée aux dimensions physiques de l'élément. Le bruit est généralement obtenu en multipliant la différence de tension entre deux états stables par le rapport d'une capacité de diaphonie sur une capacité totale du conducteur en entrée de l'élément.

Les valeurs de résistance, d'inductance et de capacité des éléments d'un circuit sont obtenues dans une liste de connectique (netlist en anglais) à partir des éléments topologiques contenus dans les masques de réalisation du circuit. Par exemple, la résistance d'un conducteur est directement proportionnelle à sa longueur et inversement proportionnelle à sa section. L'inductance d'un conducteur est généralement négligeable à l'intérieur d'un circuit intégré. Les effets capacitifs demandent des précautions particulières car pour chaque conducteur, ils dépendent des surfaces de ce conducteur en regard de surfaces d'autres conducteurs, des distances qui séparent ces surfaces et des variations de charges électriques sur ces autres conducteurs. Or, combinés à la résistance du conducteur, les effets capacitifs constituent un facteur déterminant de la constante de temps de ce conducteur.

Pour déterminer de façon simple cette constante de temps, il est d'usage de ramener l'effet de toutes les capacités entre conducteurs à celui d'une capacité unique entre le conducteur considéré et un conducteur de potentiel fixe, c'est-à-dire un conducteur ne subissant pas de variation de charge.

Dans un passé encore récent, les circuits intégrés étaient réalisés au moyen de superpositions de couches conductrices, semi-conductrices et isolantes d'épaisseur suffisamment faibles pour que les effets capacitifs, sur un conducteur considéré du circuit subissant des variations de charges, soient essentiellement ceux provoqués par les capacités entre le conducteur considéré et les conducteurs de potentiel fixe, constitués par la masse et le ou les conducteurs d'alimentation en puissance du circuit. Il suffisait alors d'additionner ces capacités considérées en parallèle pour les ramener à une capacité équivalente par rapport au substrat du circuit. On pouvait affiner la valeur de cette capacité en y ajoutant purement et simplement les capacités de couplage avec les autres conducteurs. Ces autres conducteurs, à potentiel variable pour véhiculer des signaux, avaient des capacités de couplage qui représentaient en tout état de cause des quantités négligeables. L'approximation était satisfaisante.

La connaissance de cette capacité par rapport à un potentiel fixe et de la résistance du conducteur permettait aisément de déterminer une constante de temps fonction du produit de la capacité par la résistance, sur chaque conducteur considéré. On en déduisait alors aisément le ou les instants de commutation des signaux véhiculés par ce conducteur.

L'évolution actuelle des technologies de dépôts multicouches pour réaliser des circuits intégrés permet d'augmenter l'épaisseur des couches conductrices dans une direction perpendiculaire à la surface du circuit et de diminuer corrélativement l'épaisseur des conducteurs dans le plan de la surface du circuit sans diminuer la section de ces conducteurs, et donc sans en augmenter la résistance électrique, voire en la diminuant. Ceci permet d'augmenter considérablement la densité d'intégration d'éléments par unité d'aire. D'autre part, l'augmentation d'épaisseur des couches isolantes diminue considérablement la capacité de couplage entre chaque conducteur considéré et les conducteurs à potentiel fixe. L'effet des capacités de couplage entre conducteurs à potentiel variable ne représente plus une quantité négligeable devant celui des capacités de couplage avec les conducteurs à potentiel fixe mais au contraire une quantité prédominante. L'approximation décrite dans le paragraphe précédent n'est plus satisfaisante.

La diaphonie est le phénomène physique qui, dans un conducteur électrique considéré, provoque une variation de charge liée à une variation de charge dans un autre conducteur ayant une capacité de couplage avec le conducteur considéré et qui, réciproquement provoque dans ledit autre conducteur, une variation de charge liée à une variation de charge dans le conducteur considéré. Les approximations connues de l'état de la technique pourraient conduire à une surestimation ou à une sous estimation des constantes de temps propres à chaque conducteur. Une surestimation risquerait de faire conclure qu'un circuit apte à fonctionner ne fonctionne pas. Une sous estimation risquerait de ne pas détecter l'inaptitude d'un circuit à fonctionner. On pourrait envisager de déterminer des constantes de temps pour chaque conducteur en résolvant à l'aide des mathématiques, les équations physiques qui régissent le phénomène de diaphonie. Cette solution s'avère rédhibitoire pour un circuit comportant un grand nombre de conducteurs, car bien que dénombrable, l'ensemble des variations de signaux possibles dans un circuit à très haute densité d'intégration est de dimension quasi infinie. La détermination des instants de commutation, nécessaire à s'assurer que ceux-ci tiennent dans un cycle d'horloge, pose donc un problème. De plus, la diaphonie est génératrice de bruit par les variations de charge qu'elle provoque sur un conducteur considéré, liées aux variations de charge sur d'autres conducteurs. Un problème supplémentaire est posé par la nécessité d'apprécier les conséquences de la diaphonie sur l'immunité aux bruits du circuit.

Pour pallier les problèmes précédemment cités, l'objet de l'invention est un procédé d'évaluation d'aptitude d'un circuit à très haute intégration à résister aux bruits de diaphonie, caractérisé en ce qu'il comprend : une étape de recherche d'une tranche de temps de cycle d'horloge pour chaque conducteur du circuit, dans laquelle un plus grand nombre d'intervalles temporels de commutation se produisent sur des conducteurs ayant une capacité de couplage avec le conducteur considéré ; et une étape de détermination d'aptitude d'un récepteur, branché en aval du conducteur, à résister au bruit de diaphonie provoqué par les conducteurs sur le conducteur considéré dans ladite tranche de temps.

Selon une caractéristique possible, la largeur de la tranche de temps est inversement proportionnelle à une fonction du conducteur considéré à contrer une apparition de bruit.

Selon une autre caractéristique possible, le récepteur est celui de plusieurs récepteurs ayant une plus faible immunité.

Le procédé peut aussi comprendre une étape de mesure du bruit proportionnellement à un rapport de la somme des capacités de couplage des conducteurs ayant un intervalle de commutation dans ladite tranche de temps, sur la somme de toutes les capacités de couplage existantes avec des conducteurs du circuit.

L'invention a aussi pour objet corollaire un procédé de réalisation d'un circuit électrique, tel que défini par la revendication 5.

D'autres détails seront mieux compris à l'aide de la description d'un mode préférentiel de mise en oeuvre de l'invention, dont l'exemple suit en référence aux figures.

- La figure 1a expose schématiquement une coupe de circuit à haute intensité d'intégration tel qu'on en rencontrait habituellement jusqu'à présent.

- La figure 1b expose schématiquement une coupe de circuit à haute intensité d'intégration tel que les technologies actuelles de dépôt multicouches en permettent la réalisation.

- La figure 2 expose un exemple simplifié de conducteurs électriques avec capacités de couplage.

- La figure 3 met en évidence différentes évolutions de potentiel d'un conducteur en fonction de l'état électrique du schéma de la figure 2.

- La figure 4 présente un exemple de circuit élémentaire à l'intérieur d'un circuit intégré.

- La figure 5 est un chronogramme pour représenter des instants de franchissement de seuil de commutation.

- La figure 6 présente un procédé pour obtenir les instants de commutation des éléments d'un circuit électrique.

- La figure 7 montre quelques résultats de filtrage de bruit par un noeud de circuit.

- La figure 8 met en évidence l'immunité d'un noeud de circuit.

- La figure 9 présente un procédé pour obtenir les noeuds de commutation d'un circuit électrique dont l'immunité ne permet pas de résister au bruits de diaphonie.

- La figure 10 présente une utilisation de l'invention dans un procédé de réalisation de circuits rapides à haute intégration.

La figure 1a expose schématiquement une coupe de circuit à haute intensité d'intégration tel qu'on en rencontrait habituellement jusqu'à présent. Sur un substrat polycristallin 22, sont réalisés des microéléments 28 tels que diodes, résistances ou transistors, dans une couche d'oxyde 21. La couche 21 est surmontée par une couche métallique 20 où cheminent des conducteurs de section 23, 24. La couche 20 est surmontée par une couche 19 d'oxyde, couverte par une couche métallique 18, mise à un potentiel fixe Vss ou Vdd. Les couches précédemment décrites peuvent être répétées par superposition de façon à obtenir des circuits multicouches. Le conducteur de section 23 présente une capacité de couplage 30 avec la couche métallique 18 et une capacité de couplage 32 avec le substrat 22. Le conducteur de section 24 présente une capacité de couplage 31 avec la couche métallique 18 et une capacité de couplage 33 avec le substrat 22. La hauteur des sections 23, 24 est suffisamment faible et les conducteurs de section 23, 24 sont suffisamment éloignés, comparativement à la faible épaisseur des couches 19 à 21, pour négliger toute capacité de couplage entre les conducteurs de section 23, 24, devant les capacités de couplage 30, 31, 32, 33. Les couches 18 et 22 étant chacune à un potentiel fixe, par exemple Vss et Vdd, on ramène habituellement la somme des capacités 30, 32, à une capacité équivalente Cs par rapport au substrat.

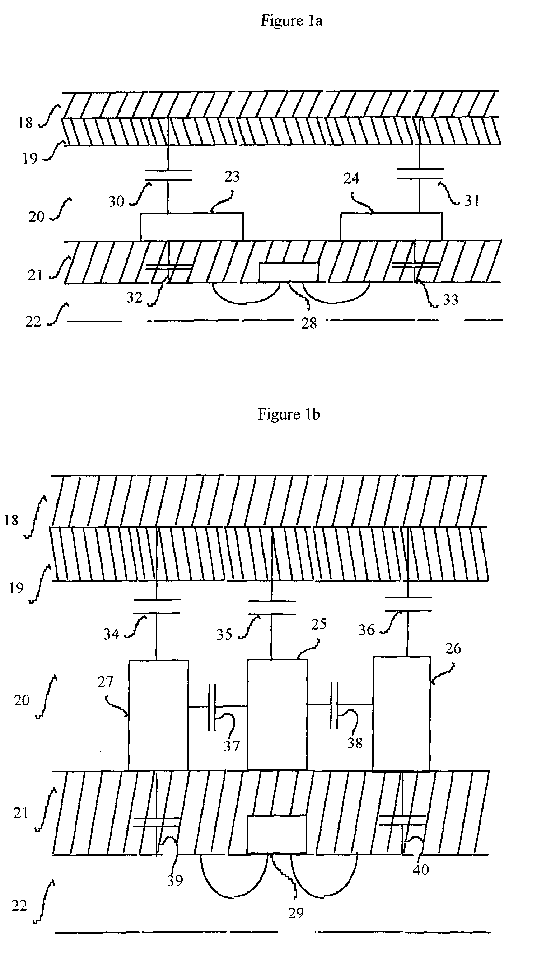

La figure 1b expose schématiquement une coupe de circuit à haute intensité d'intégration tel que les technologies actuelles de dépôt multicouches en permettent la réalisation. Ces technologies offrent la possibilité d'augmenter l'épaisseur des couches 18 à 22. En réduisant la largeur de sections de conducteurs 25, 26, 27, il est possible d'augmenter la densité d'intégration de conducteurs électriques par unité de surface. Cette densité d'intégration est encore augmentée par la possibilité de réduire les distances entre conducteurs. En augmentant la hauteur des sections de conducteurs 25, 26, 27, il est possible d'en réduire la résistance électrique pour y faire circuler des densités de courant au moins égales à celles circulant dans les sections 23, 24, exposées en figure 1a. L'augmentation d'épaisseur des couches d'oxyde 19 et 21 a pour effet de réduire les valeurs de capacités de couplage 34, 35, 36 des conducteurs avec la couche métallique 18 et les valeurs de capacités de couplage 39, 40 des conducteurs avec le substrat 22. Les valeurs de capacités de couplage 37, 38, entre conducteurs de section 25 et 27, respectivement de section 25 et 26, ne sont plus négligeables et peuvent même avoir un effet prépondérant sur les capacités de couplage 34, 35, 36, 39, 40.

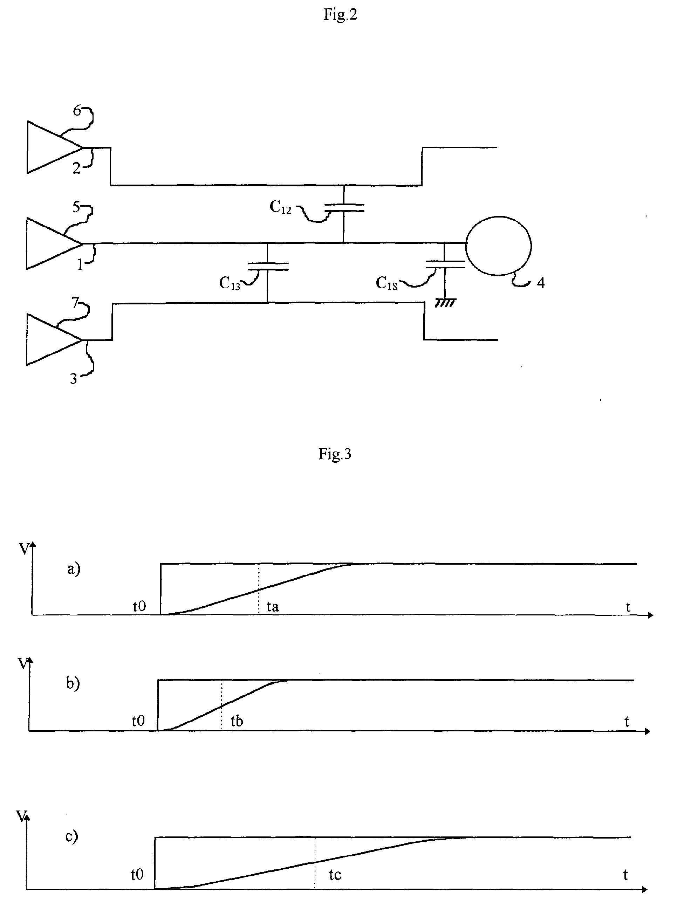

Sur la figure 2, un conducteur 1 est destiné à transmettre des signaux logiques depuis un émetteur 5 vers un récepteur 4. De même, des conducteurs 2 et 3 sont destinés à transmettre des signaux logiques respectivement depuis des émetteurs 6 et 7 vers des récepteurs non représentés. Le conducteur 1 présente une capacité $C_{1s}$ de couplage avec les potentiels fixes Vss et Vdd de référence du circuit. D'autre part, le conducteur 1 de résistance $R_1$, présente une capacité $C_{12}$ et une capacité $C_{13}$ de couplage avec respectivement le conducteur 2 et le conducteur 3. Lorsque l'émetteur 5 commute à un instant t0 sur une nouvelle valeur de potentiel, différente de celle précédent l'instant t0, le conducteur 1 atteint la nouvelle valeur de potentiel avec une constante de temps qui dépend de la résistance du conducteur 1 et du courant de charge de chacune des capacités de couplage du conducteur 1 avec les autres éléments du circuit.

La figure 3 met en évidence différentes évolutions de potentiel du conducteur 1 en fonction de l'état électrique du schéma de la figure 2.

La figure 3a) représente le cas où, de l'instant t0 auquel l'émetteur 5 commute sur la nouvelle valeur de potentiel jusqu'à un instant ta où l'atteinte d'une tension de seuil provoque une commutation du récepteur 4, les valeurs de potentiel des conducteurs 2 et 3 sont constantes. Le conducteur présente une capacité $C_T$ égale à la somme des capacités $C_{12}$, $C_{13}$ et $C_{1S}$ disposées en parallèle. La résistance $R_1$ définit une constante de temps telle que sa valeur de potentiel atteint le seuil de commutation du récepteur 4 à l'instant ta.

La figure 3b) représente le cas où, de l'instant t0 auquel l'émetteur 5 commute sur la nouvelle valeur de potentiel jusqu'à un instant tb où l'atteinte d'une tension de seuil provoque une commutation du récepteur 4, les valeurs de potentiel des conducteurs 2 et 3 évoluent de façon identique à celle du conducteur 1. Ce cas extrême se présente par exemple lorsque les conducteurs 2 et 3 ont la même valeur initiale de potentiel, et lorsque les émetteurs 6 et 7 commutent au même instant t0 que l'émetteur 5. La différence de potentiel aux bornes des capacités $C_{12}$, $C_{13}$ reste nulle à tout instant et celles-ci ne modifient donc pas leur charge. Tout se passe comme si ces capacités n'existaient pas. Le conducteur présente alors une capacité $C_T$ égale à la capacité $C_{1S}$. La résistance $R_1$ définit une constante de temps telle que la valeur de potentiel du conducteur 1 atteint le seuil de commutation du récepteur 4 à l'instant tb. L'instant tb précède l'instant ta du cas précédent car la capacité $C_T$ apparente du conducteur 1 est plus faible. La figure 3b) représente le cas dans lequel le récepteur 4 commute avec un retard tb-t0 minimal après la commutation de l'émetteur 5 car seule la capacité $C_{1S}$ agit sur la constante de temps.

La figure 3c) représente le cas où, de l'instant t0 auquel l'émetteur 5 commute sur la nouvelle valeur de potentiel jusqu'à un instant tc où l'atteinte d'une tension de seuil provoque une commutation du récepteur 4, les valeurs de potentiel des conducteurs 2 et 3 évoluent de façon inverse à celle du conducteur 1. Ce cas extrême se présente par exemple lorsque les conducteurs 2 et 3 ont une valeur initiale de potentiel inverse, et lorsque les émetteurs 6 et 7 commutent au même instant t0 que l'émetteur 5. Tout se passe sensiblement comme si les capacités $C_{12}$, $C_{13}$ avaient une valeur double de leur valeur réelle. Le conducteur présente alors une capacité $C_T$ égale à la capacité $C_{1S}$ à laquelle s'ajoute le double de la somme des capacités $C_{12}$, $C_{13}$. La résistance $R_1$ définit une constante de temps telle que la valeur de potentiel du conducteur 1 atteint le seuil de commutation du récepteur 4 à l'instant tc. L'instant tc succède à l'instant ta du premier cas car la capacité $C_T$ apparente du conducteur 1 est plus forte. La figure 3c) représente le cas dans lequel le récepteur 4 commute avec un retard tc-t0 maximal après la commutation de l'émetteur 5 car seule les capacités entre conducteurs agissent sensiblement pour le double de leur valeurs sur la constante de temps.

Entre les cas extrêmes représentés en figure 3b) et 3c), une infinité de cas peuvent se présenter pour lesquels l'instant où l'atteinte d'une tension de seuil provoque une commutation du récepteur 4, se situe dans l'intervalle [tb,tc]. Par exemple, si à la commutation de l'émetteur 5, l'émetteur 6 ne commute pas et l'émetteur 7 commute en sens inverse, CT = $C_{1S}$ + $C_{12}$ + 2*$C_{13}$.

D'autre part, entre les cas où une capacité de couplage intervient pour une valeur nulle et celui pour lequel elle intervient pour une valeur double, il convient surtout de retenir qu'une capacité de couplage intervient pour sa valeur réelle si l'autre conducteur est à une valeur de tension stable. La capacité de couplage intervient pour une valeur inférieure à sa valeur réelle si les tensions sur les deux conducteurs évoluent dans le même sens. La capacité de couplage intervient pour une valeur supérieure à sa valeur réelle si les tensions sur les deux conducteurs évoluent en sens opposé.

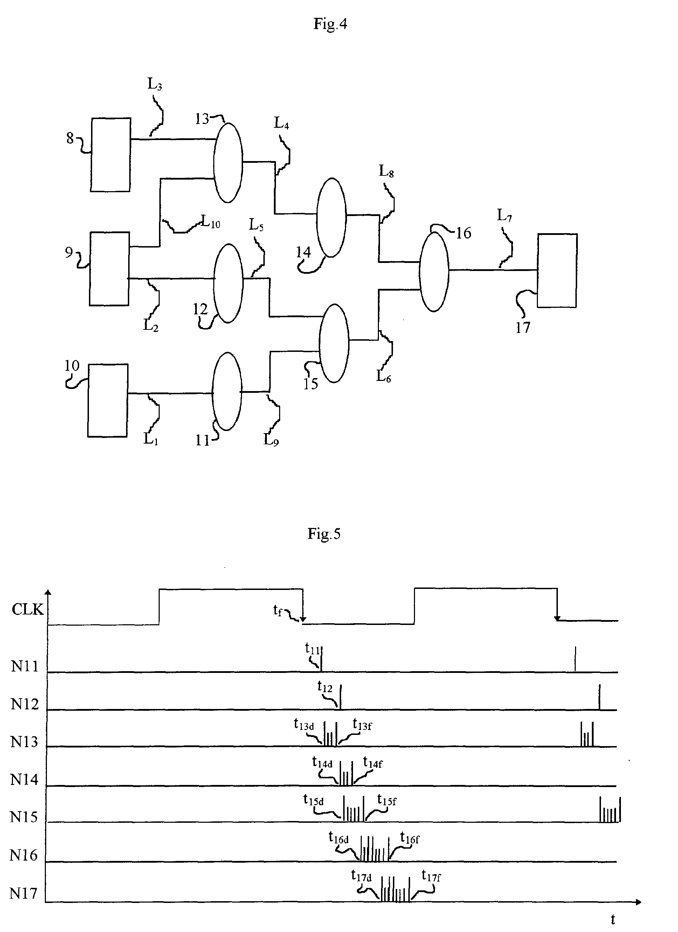

La figure 4 présente un exemple de circuit élémentaire à l'intérieur d'un circuit intégré, pour réaliser une combinaison logique de signaux issus de registres d'entrée 8, 9, 10, dont le résultat est disponible dans un registre 17. Pour simplifier les explications, on entend ici par registre tout agencement d'une ou plusieurs bascules (flip-flop en anglais). Des noeuds 11 à 16 sont composés de transistors pour obtenir en sortie de chaque noeud un signal binaire résultant de signaux d'entrée sur ce noeud. Le noeud 11 reçoit en entrée un signal issu du registre 10. Le noeud 12 reçoit en entrée un signal issu du registre 9. Le noeud 13 reçoit en entrée un signal issu du registre 8 et un signal issu du registre 9. Le noeud 14 reçoit en entrée un signal issu de la sortie du noeud 13. Le noeud 15 reçoit en entrée un signal issu de la sortie du noeud 11 et un signal issu de la sortie du noeud 12. Le noeud 16 reçoit en entrée un signal issu de la sortie du noeud 14 et un signal issu de la sortie du noeud 15. Le signal de sortie du noeud 16 est reçu en entrée du registre 17.

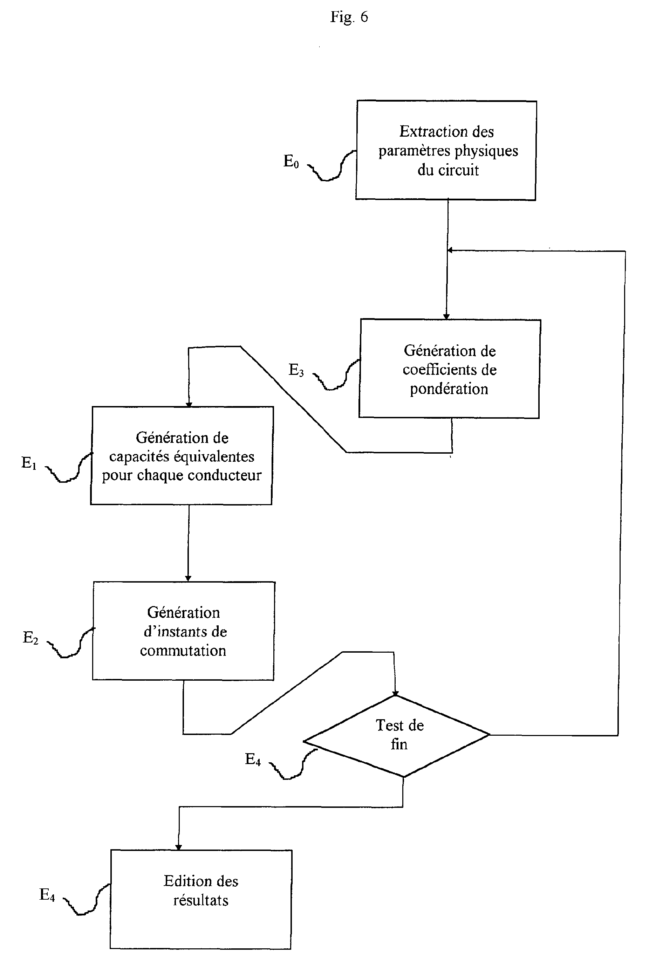

La figure 5 est un chronogramme portant le temps en abscisse de façon à représenter pour chaque élément 11 à 17 de la figure 4, les instants de franchissement de seuil de commutation, tel que défini précédemment en référence à la figure 3, en entrée de l'un de ces éléments.

La première ligne CLK représente l'état logique d'une horloge dont, par exemple, le front descendant à un instant $t_f$ détermine l'émission d'un signal binaire en sortie des registres 8 à 10.

Sur la ligne N11, le signal émis du registre 10 est susceptible de provoquer une commutation en entrée du noeud 11 à un instant $t_{11}$. Le retard $t_{11}$ - $t_f$ résulte des capacités de couplage du conducteur reliant la sortie du registre 10 à l'entrée du noeud 11 tel qu'expliqué précédemment en référence aux figures 2 et 3.

Sur la ligne N12, le signal émis du registre 9 est susceptible de provoquer une commutation en entrée du noeud 12 à un instant $t_{12}$. Le retard $t_{12}$ - $t_f$ résulte des capacités de couplage du conducteur reliant la sortie du registre 9 à l'entrée du noeud 12 tel qu'expliqué précédemment en référence aux figures 2 et 3.

Sur la ligne N13, le signal émis du registre 8 est susceptible de provoquer une commutation en entrée du noeud 13 à un instant $t_{13d}$. Le retard $t_{13d}$ - $t_f$ résulte des capacités de couplage du conducteur reliant la sortie du registre 8 à l'entrée du noeud 13 tel qu'expliqué précédemment en référence aux figures 2 et 3. Le signal émis du registre 9 est susceptible de provoquer une commutation en entrée du noeud 13 à un instant $t_{13f}$. Le retard $t_{13f}$ - tf résulte des capacités de couplage du conducteur reliant la sortie du registre 9 à l'entrée du noeud 13. Entre les instants $t_{13d}$ et $t_{13f}$, la commutation du noeud 13 est indéterminée. Cette indétermination est symbolisée par les petites hachures verticales.

Sur la ligne N14, l'indétermination de commutation du noeud 13 se reporte en entrée du noeud 14 de $t_{14d}$ à $t_{14f}$. Le retard $t_{14d}$ - $t_{13d}$ résulte des capacités de couplage du conducteur reliant la sortie du noeud 13 à l'entrée du noeud 14 et du temps de commutation intrinsèque du noeud 13.

Sur la ligne N15, le signal émis du noeud 11 est susceptible de provoquer une commutation en entrée du noeud 15 à un instant $t_{15d}$. Le retard $t_{15d}$ - $t_{11}$ résulte des capacités de couplage du conducteur reliant la sortie du noeud 11 à l'entrée du noeud 15 et du temps de commutation intrinsèque du noeud 11. Le signal émis du noeud 12 est susceptible de provoquer une commutation en entrée du noeud 15 à un instant $t_{15f}$. Le retard $t_{15f}$ - $t_{12}$ résulte des capacités de couplage du conducteur reliant la sortie du noeud 12 à l'entrée du noeud 15 et du temps de commutation intrinsèque du noeud 12. Entre les instants $t_{15d}$ et $t_{15f}$, la commutation du noeud 15 est indéterminée. Cette indétermination est symbolisée par les petites hachures verticales.

Sur la ligne N16, l'indétermination de commutation du noeud 14 et l'indétermination de commutation du noeud 15 se reportent en entrée du noeud 16 de $t_{16d}$ à $t_{16f}$ . Le retard $t_{16d}$ - $t_{14d}$ résulte des capacités de couplage du conducteur reliant la sortie du noeud 14 à l'entrée du noeud 16 et du temps de commutation intrinsèque du noeud 14. Le retard $t_{16f}$- $t_{15f}$ résulte des capacités de couplage du conducteur reliant la sortie du noeud 15 à l'entrée du noeud 16 et du temps de commutation intrinsèque du noeud 15.

Sur la ligne N17, l'indétermination de commutation du noeud 16 se reporte en entrée du registre 17 de $t_{17d}$ à $t_{17f}$. Le retard $t_{17d} - t_{17d}$ résulte des capacités de couplage du conducteur reliant la sortie du noeud 16 à l'entrée du registre 17 et du temps de commutation intrinsèque du noeud 16.

Les explications qui précèdent sont valables pour chaque front descendant du signal d'horloge CLK tel qu'on l'observe sur la partie droite du chronogramme.

La figure 6 présente un procédé pour obtenir les instants de commutation des éléments d'un circuit électrique.

En étape E0, les paramètres physiques du circuit sont extraits, par exemple des masques de production qui constituent une image fidèle du circuit produit à partir de ces masques. Ces paramètres physiques sont inventoriée dans une liste de connectique (netlist en anglais). L'extraction à partir des masques n'est pas nécessaire si on possède déjà une liste de connectique comprenant pour chaque conducteur électrique $L_i$ du circuit, les valeurs de sa résistance $R_i$ et des capacités réelles $C_{ij}$ existantes de couplage avec les autres conducteurs $L_j$ dont font partie la masse au potentiel fixe Vss et les conducteurs d'alimentation au potentiel fixe Vdd.

En étape E1 est générée pour chaque conducteur $L_i$ du circuit, une valeur de capacité $C_{Ti}$ équivalente de couplage par rapport à une masse de potentiel fixe. Un dispositif, tel que par exemple un ordinateur, calcule une somme des valeurs de capacités réelles $C_{ij}$ existantes de couplage de conducteurs $L_j$ du circuit avec le conducteur $L_i$. Chaque capacité $C_{ij}$ est affectée d'un coefficient de pondération $K_{ij}$.

Une étape E2 succède à l'étape E1. Un dispositif, tel que par exemple l'ordinateur utilisé en étape E1, génère un intervalle temporel de commutation $[t_{id}, t_{if}]$ sur chaque conducteur $L_i$. L'intervalle temporel de commutation $[t_{id}, t_{if}]$ généré est stocké dans une structure de données pour des traitements ultérieurs tel que par exemple, simplement une édition de résultats. Pour générer l'intervalle temporel de commutation, le dispositif calcule une constante de temps $\tau_i$ propre au conducteur $L_i$, fonction de la capacité équivalente $C_{Ti}$ générée en étape E1. Une fonction simple connue est $\tau_i = R_i \times C_{ti}$. L'instant de commutation $t_{id}$ est calculé en fonction de la constante de temps $\tau_i$ et de l'instant de la première émission en sortie de l'émetteur situé en amont du conducteur. L'instant de commutation $t_{if}$ est calculé en fonction de la constante de temps $\tau_i$ et de l'instant de la dernière émission en sortie de l'émetteur situé en amont du conducteur. Si ces instants de première et dernière émission ne sont pas déjà dans la structure de données ci-dessus mentionnée, le dispositif commence par les générer en fonction des instants de commutation des conducteurs situés en amont de l'émetteur considéré, et ainsi de suite, si besoin est, jusqu'à remonter aux bascules à l'origine des variations de signaux. Chaque émission originelle est faite à un instant $t_f$ de front d'horloge. Des valeurs de $t_{id}$ et de $t_{if}$, résultant d'un calcul strict ne correspondent pas nécessairement rigoureusement à la réalité, on peut alors retenir une valeur de $t_{id}$ légèrement inférieure à la valeur calculée et une valeur de $t_{if}$ légèrement supérieure à la valeur calculée, de façon à englober l'intervalle $[t_{id}, t_{if}]$ avec une marge d'erreur acceptable.

Pour mieux adapter les coefficients de pondération $K_{ij}$ au comportement du circuit, une étape E3 précède l'étape E1 pour générer ces coefficients de pondération. Un dispositif doté de moyens de traitement numérique scrute chaque conducteur $L_i$ dans la structure de données dont il dispose. Le dispositif scrute ensuite dans la structure de données, chaque conducteur $L_j$ ayant une capacité réelle $C_{ij}$ existante de couplage avec le conducteur $L_i$ considéré. Pour chaque paire de conducteurs $L_i$, $L_j$, le dispositif recherche s'il existe un intervalle temporel de commutation $[t_{id}, t_{if}]$ sur le conducteur $L_i$ et un intervalle temporel de commutation $[t_{jd}, t_{jf}]$ sur le conducteur $L_j$ avec une partie commune.

Si le dispositif ne détecte aucune information sur une existence de partie commune, il affecte une valeur unitaire au coefficient de pondération $K_{ij}$. En effet, aucune information n'existe alors selon laquelle le conducteur Lj se comporte autrement que comme un conducteur à potentiel fixe pendant une commutation sur le conducteur $L_i$. Ceci est toujours le cas pour les conducteurs au potentiel fixe Vss ou Vdd.

Si le dispositif détecte une information sur l'existence d'une partie commune, il recherche si la commutation se fait sur une valeur identique pour les conducteurs $L_i$ et $L_j$ dans cette partie commune. Il est par exemple possible que ce deuxième niveau d'information soit disponible lorsque les conducteurs $L_i$ et Lj véhiculent un même signal.

En absence de ce deuxième niveau d'information, le dispositif affecte au coefficient $K_{ij}$ une valeur supérieure à la valeur unitaire. En effet, aucune information n'existe alors selon laquelle une évolution de charge du conducteur $L_j$ ne s'oppose pas à une évolution de charge du conducteur $L_i$. Or, dans une évaluation de performance, il est préférable de considérer le cas le plus défavorable. En tenant compte de l'enseignement donné en référence à la figure 3, un choix simple pour la valeur du coefficient $K_{ij}$ est une valeur double.

En présence de ce deuxième niveau d'information, le dispositif affecte au coefficient $K_{ij}$ une valeur inférieure à la valeur unitaire. En effet, une information existe alors selon laquelle une évolution de charge du conducteur $L_j$ ne s'oppose pas, voire contribue à une évolution de charge du conducteur $L_i$. Or, dans une évaluation de performance, il est préférable de tenir compte d'un cas favorable pour ne pas sous évaluer à tors cette performance. En tenant compte de l'enseignement donné en référence à la figure 3, un choix simple pour la valeur du coefficient $K_{ij}$ est une valeur nulle.

L'étape E3 est d'autant plus performante que la quantité d'information dont elle dispose sur les intervalles de commutation, est conséquente. L'étape E2 génère des intervalles de commutation qu'il est intéressant d'utiliser dans l'étape E3. Une amélioration du procédé décrit consiste à reboucler la sortie de l'étape E2 sur l'entrée de l'étape E3. Une étape E4 est intercalée entre les étapes E2 et E3, de façon à pouvoir sortir de la boucle ainsi constituée par les étapes E1 à E3.

L'étape E4 constitue un test de fin, qui en cas de rupture de la boucle, amène à une étape E4 pour éditer les intervalles de commutation générés en étape E2. Différents tests peuvent être envisagés en étape E4. On peut par exemple utiliser l'incrémentation d'un compteur à chaque passage dans l'étape E4 et déclencher un signal de fin lorsque le contenu de ce compteur dépasse une valeur de seuil prédéterminée. On peut encore comparer un ou plusieurs instants de commutation, par exemple le plus tardif après le front d'horloge, généré avant le branchement précédent sur l'étape E3, à celui généré en sortie de l'étape E2, et déclencher un signal de fin si les deux instant ne diffèrent pas plus que d'une quantité prédéterminée. Tous les tests imaginables sont possibles sans sortir du cadre de la présente invention.

On peut envisager que l'enchaînement des étapes E3 à E2 se fait après avoir systématiquement scruté l'ensemble des conducteurs du circuit dans chacune des étapes E3, E1, E2. On peut aussi envisager que l'enchaînement des étapes E3 à E2 se fait après avoir scruté les conducteurs ayant une capacité de couplage avec un conducteur considéré. Les rebouclages par l'étape E4 se font alors de proche en proche jusqu'à scruter l'ensemble des conducteurs du circuit.

Regardons à présent comment le procédé décrit en référence à la figure 6 peut fonctionner sur un circuit du type de celui décrit en référence à la figure 4.

En étape E0, chacun des conducteurs $L_i$, $L_j$, les indices i et j variant de 1 au nombre total de conducteurs du circuit, dix dans le cas exposé en figure 4, est répertorié dans une structure de donnée avec ses caractéristiques physiques.

Au passage de l'étape E0 à l'étape E3, aucun intervalle de commutation n'est connu a priori. En étape E3, les coefficients de pondération sont donc tous initialisés à une valeur unitaire.

En étape E1, la capacité de couplage de chaque conducteur est alors calculée par une première approximation qui consiste à supposer que, lorsqu'un conducteur considéré $L_i$ commute, aucun autre conducteur $L_j$ voisin ne commute. Comme expliqué en référence aux figures 2 et 3, la capacité totale $C_{Ti}$ de couplage ramenée au substrat est égale à la somme de la capacité réelle de couplage au substrat $C_{Si}$ et des capacités $C_{ij}$ de couplage du conducteur $L_i$ aux n conducteurs Lj voisins.

$$C_{Ti} = C_{Si} + \Sigma\ C_{ij}$$

($j \neq i$, j allant de 1 à n, $n \leq 10$)

En étape E2, les instants et les intervalles de commutation succédant à un instant déterminé $t_f$ de front d'horloge, sont calculés pour chaque noeud du circuit analysé, sur un modèle conforme aux explications de la figure 3, à partir de la capacité $C_{Ti}$ calculée à l'étape E1. On obtient ainsi des résultats similaires à ceux de la figure 5.

L'étape E4 rebranche ensuite le procédé sur l'étape E3 où les coefficients de pondération sont recalculés.

La combinaison des étapes E3 et E1 génère à nouveau une capacité $C_{Ti}$ pour chaque conducteur joignant deux noeuds en utilisant les résultats précédents de l'étape E2. Prenons par exemple le cas de la figure 5.

Pour recalculer la capacité $C_{T1}$ du conducteur L1, tous les conducteurs Lj avec lesquels le conducteur L1 a une capacité de couplage $C_{1j}$ sont considérés. Dans l'intervalle de temps $[t_{11} - t_f]$ d'émission d'un signal sur le conducteur L1, des signaux de signe inconnu sont émis sur les conducteurs L2, L10 et L3. Aucun signal n'est émis sur les conducteurs L4 à L9. La capacité maximale de couplage $C_{T1}$ est donnée par la formule:

$$C_{T1} = C_{S1} + 2(C_{12} + C_{13} + C_{110})$$

Pour recalculer la capacité $C_{T2}$ du conducteur L2, tous les conducteurs Lj avec lesquels le conducteur L2 a une capacité de couplage $C_{2j}$ sont considérés. Dans l'intervalle de temps $[t_{12} - t_f]$ d'émission d'un signal sur le conducteur L2, un signal de même signe est émis sur le conducteur L10, des signaux de signe inconnu sont émis sur les conducteurs L1, L3, L4 et L9. Aucun signal n'est émis sur les conducteurs L5 à L8. La capacité maximale de couplage $C_{T2}$ est donnée par la formule:

$$C_{T2} = C_{S2} + C_{210} + 2(C_{21} + C_{23} + C_{24} + C_{29})$$

Pour recalculer la capacité $C_{T3}$ du conducteur L3, tous les conducteurs Lj avec lesquels le conducteur L3 a une capacité de couplage $C_{3j}$ sont considérés. Dans l'intervalle de temps $[t_{13d} - t_f]$ d'émission d'un signal sur le conducteur L2, des signaux de signe inconnu sont émis sur les conducteurs L1, L2, L10 et L9. Aucun signal n'est émis sur les conducteurs L4 à L8. La capacité maximale de couplage $C_{T2}$ est donnée par la formule:

$$C_{T3} = C_{S3} + 2(C_{310} + C_{32} + C_{31} + C_{39})$$

Et ainsi de suite jusqu'au conducteur L7.

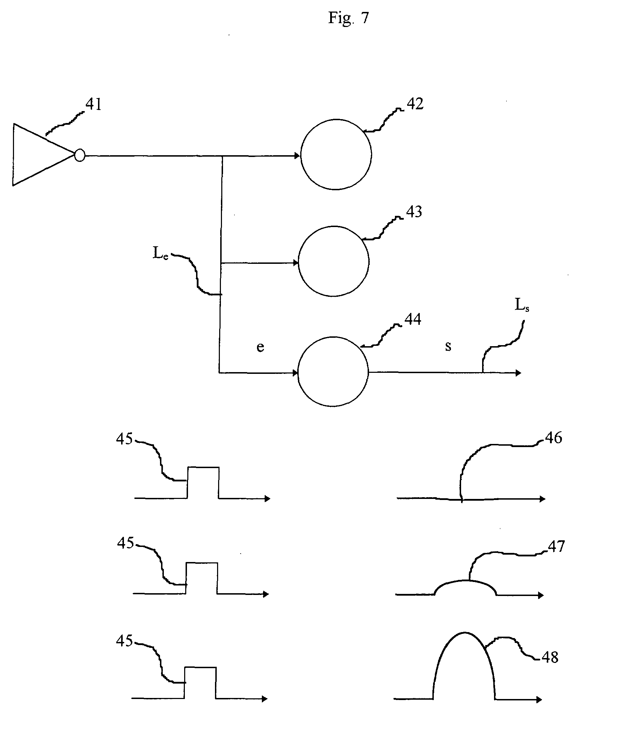

La figure 7 montre différentes aptitudes possibles d'un noeud 44 à résister au bruit. Le noeud 44 se comporte en récepteur sur une entrée e soumise à la tension d'un conducteur $L_e$. Cette tension résulte de signaux émis par un noeud 41, éventuellement émis vers d'autres noeuds 42, 43. Cette tension résulte aussi de bruits transmis sur le conducteur $L_e$. Les bruits transmis sur le conducteur sont d'origines diverses, variations de tension d'alimentation, diaphonie. Recevant une tension en entrée, le noeud 44 se comporte alors comme un émetteur en sortie s sur un conducteur $L_s$. Un bruit 45 reçu en entrée est parfaitement filtré si la variation de tension 46 en sortie du noeud 44 qui en résulte, est nulle. Le bruit 45 reçu en entrée est atténué si la variation de tension 47 en sortie qui en résulte en sortie du noeud 44, est plus faible que celle du bruit 45. Le bruit 45 est amplifié si la variation de tension 48 en sortie, est plus élevée que celle du bruit 45. Ces explications restent valables pour tout récepteur 42, 43 du circuit. Le noeud 41 constitue un émetteur amont pour les noeuds 41 à 43.

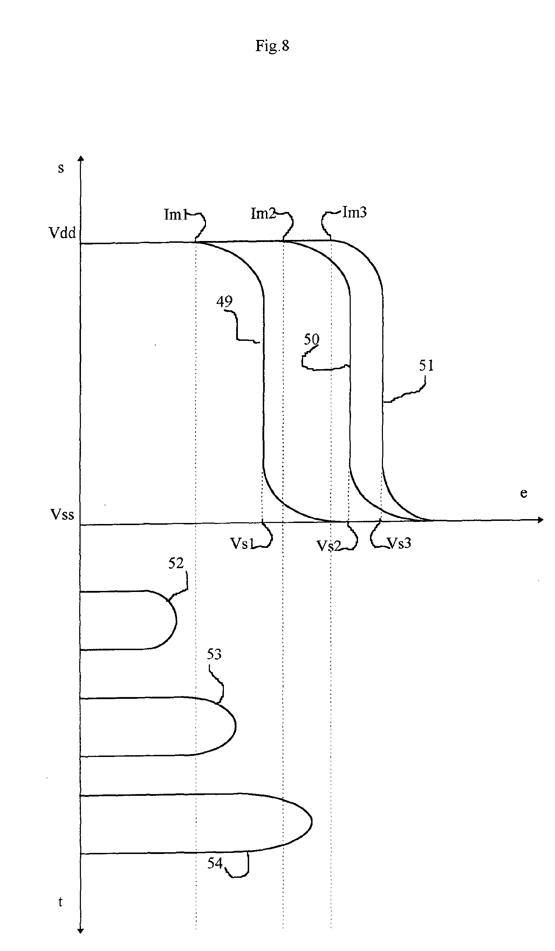

La figure 8 expose de façon simplifiée, différentes courbes 49, 50, 51, possibles d'évolution de tension de sortie s, portées en ordonnée ascendante, en fonction de la tension d'entrée e, portée en abscisse, du noeud 44 constitué dans cet exemple d'un inverseur. La partie verticale de chacune des courbes 49, 50, 51, définit respectivement une tension de seuil de commutation Vs1, Vs2, Vs3, au delà de laquelle la tension de sortie s bascule de la tension Vdd à la tension Vss.

L'immunité du noeud 44 est la valeur de tension Im1, Im2, Im3 au-delà de laquelle la sortie s quitte sa tension d'équilibre sur la courbe caractéristique du noeud.

En ordonnée descendante sont représentées dans le temps t, différentes tensions de bruit 52, 53, 54 sur l'entrée e. Si la courbe caractéristique du noeud est la courbe 49, on observe qu'un niveau de tension de bruit 52 inférieur à la valeur de tension Im1, laisse la sortie s dans son état stable. Le bruit est parfaitement filtré. Par contre, un niveau de tension de bruit 53 supérieur à la valeur de tension Im1, fait légèrement quitter la sortie s de son état stable. Le bruit est atténué. Un niveau de tension de bruit 54 supérieur à la valeur de tension Vs1 provoque une commutation de la sortie sur le potentiel Vss. Le bruit est amplifié. En dimensionnant le noeud 44 de façon à ce que sa courbe caractéristique soit la courbe 50, le niveau de bruit 53 est parfaitement filtré mais le niveau de bruit 54 est seulement atténué. En dimensionnant le noeud 44 de façon à ce que sa courbe caractéristique soit la courbe 51, les trois niveaux de bruit sont parfaitement filtrés. En dimensionnant le noeud 44, il convient cependant de ne pas trop élever la tension de seuil Vs3 de façon à ne pas faire perdre sa sensibilité en commutation sur un vrai signal au noeud 44. D'autres solutions consistent à diminuer le niveau de bruit en augmentant la puissance du noeud émetteur amont 41, en diminuant la résistance du conducteur $L_e$ ou en éradiquant la source de ce bruit.

L'aptitude du conducteur $L_e$ à contrer une apparition de bruit d'origine extérieure est une fonction f (Pam, RL) où Pam est la puissance d'émission du noeud amont 41 et RL est la résistance du conducteur $L_e$. Plus forte est la puissance Pam du noeud émetteur en amont et plus faible est la résistance RL du conducteur, plus le noeud amont est capable de générer de courant pour annuler dans le conducteur les charges provoquées par des bruits d'origine extérieure.

Le bruit Bu d'origine diaphonique auquel se rapporte la suite de la description, se calcule par la formule :

$$Bu = Vdd\ (C_D\ /\ C_T)$$

où $C_D$ est la capacité de diaphonie et $C_T$ est la capacité totale du conducteur.

Dans une tranche de temps donnée, la capacité de diaphonie $C_D$ est la somme des capacités de couplage $C_{ej}$ du conducteur $L_e$ avec les conducteurs Lj en commutation, dans la mesure où les capacités de couplage existent. La capacité totale $C_T$ est la somme des capacités de couplage $C_{ei}$ du conducteur $L_e$ avec tous les conducteurs Li du circuit, dans la mesure où les capacités de couplage existent.

Un noeud récepteur 44 est apte à résister au bruit si son immunité Im vérifie l'inéquation :

$$Im > Bu\ /\ f(Pam, RL).$$

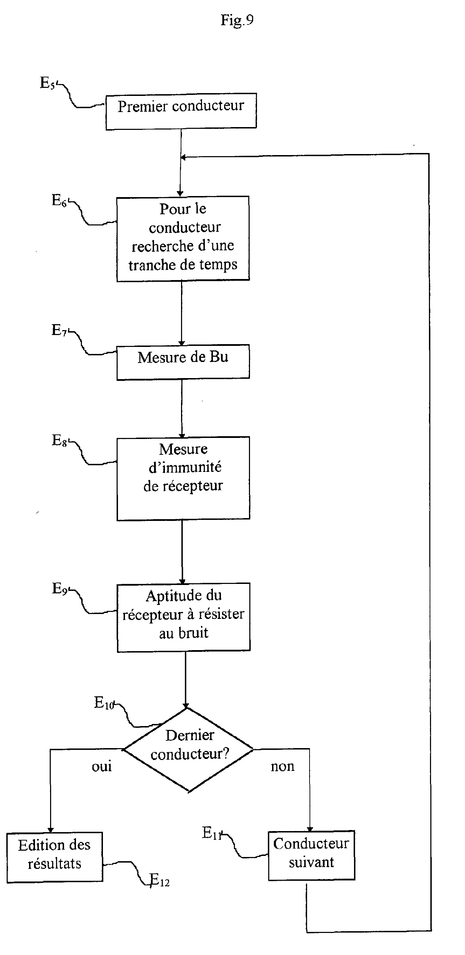

La figure 9 présente un procédé pour obtenir les noeuds de commutation d'un circuit électrique dont l'immunité ne permet pas de résister au bruits de diaphonie.

Le procédé est initialisé en étape E5 où est scruté un premier conducteur $L_e$ du circuit dans la liste de connectique.

En étape E6 est recherchée une tranche de temps dans un cycle d'horloge, durant laquelle un plus grand nombre de conducteurs $L_i$ ayant une capacité de couplage $C_{ei}$ avec le conducteur $L_e$ commutent. La largeur de la tranche de temps est inversement proportionnelle à l'aptitude f(Pam, RL) du conducteur $L_e$, de sorte que l'émetteur amont ait le temps d'annuler les charges provoquées par les commutations des conducteurs $L_i$. Le nombre de conducteurs est déterminé en comptant les conducteurs $L_i$ qui ont des instants de commutation dans la tranche de temps. Ces instants de commutations sont par exemple ceux générés dans l'étape E2.

En étape E7 est calculée une capacité de diaphonie $C_{De}$ du conducteur $L_e$ comme étant la somme des capacités de couplage $C_{ei}$ des conducteurs $L_i$ qui commutent dans la tranche de temps déterminée dans l'étape E6. La capacité totale $C_{Te}$ du conducteur $L_e$ est définie comme étant la somme des capacités de cou-

plage $C_{ek}$ de tous les conducteurs $L_k$ en ayant une avec le conducteur $L_e$ considéré. Le bruit Bu sur le conducteur $L_e$ est mesuré par le produit de la tension d'alimentation Vdd du circuit avec le rapport de la capacité de diaphonie $C_{De}$ à la capacité totale $C_{Te}$ du conducteur $L_e$ considéré.

L'étape E8 peut être exécutée indifféremment avant l'étape E6, après l'étape E7 ou en parallèle avec les étapes E6 et E7. La liste de connectique contient pour chaque conducteur $L_e$ une liste d'un ou plusieurs noeuds récepteurs 42, 43, 44 branchés sur ce conducteur, avec pour chaque récepteur la valeur de son immunité Im. Le noeud récepteur avec la valeur d'immunité Im la plus faible est retenu.

En étape E9, la valeur d'immunité retenue en étape E8 est comparée avec le rapport du bruit Bu à la fonction f(Pam, RL) du conducteur $L_e$ considéré. Si l'immunité Im est supérieure au rapport Bu/f(Pam,RL), le bruit Bu est parfaitement filtré. Dans le cas contraire, le noeud de commutation retenu en étape E8 possède une immunité qui ne permet pas de résister au bruits de diaphonie. Le descriptif de ce noeud est alors conservé dans une structure de données.

En étape E10, si le conducteur $L_e$ considéré est le dernier conducteur de la liste de connectique, le procédé termine par l'étape E12. Sinon, le procédé continue en étape E11 où le conducteur suivant de la liste de connectique est considéré. L'étape E11 reboucle sur les étapes E6 à E10.

En étape E12 est éditée la structure de données contenant les noeuds dont l'immunité ne permet pas de résister aux bruits de diaphonie. Le fait que la structure de donnée soit vide, signifie que tous les noeuds du circuit ont une immunité qui permet de résister aux bruits de diaphonie.

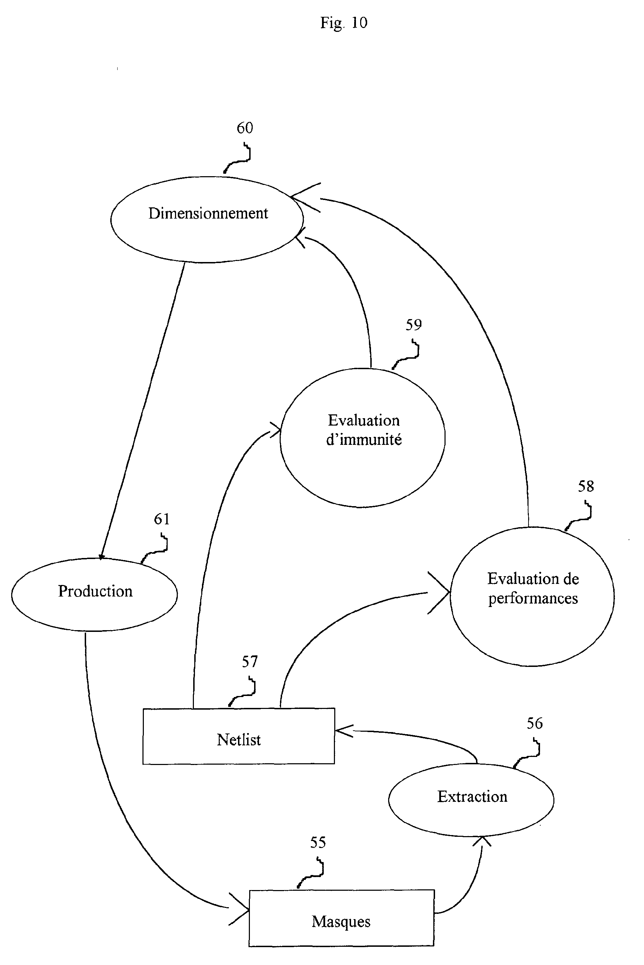

La figure 10 présente une utilisation de l'invention dans un procédé de réalisation de circuits rapides à haute intégration. Un circuit intégré est communément gravé dans un matériau semi-conducteur à partir de masques 55. Les masques 55 représentent donc une image fidèle de la structure physique du circuit. Une phase d'extraction 56 permet d'obtenir à partir des masques, une liste de connectique 57 qui contient, sous forme d'une structure de données informatique, une liste de tous les conducteurs du circuit et des noeuds que ces conducteurs relient entre eux. La liste contient aussi les caractéristiques physiques de ces conducteurs et de ces noeuds. Ces caractéristiques physiques permettent de déterminer par exemple, la résistance RL et les capacités de couplage de chaque conducteur, le seuil de commutation, l'immunité et la puissance d'émission de chaque noeud.

A partir de la liste de connectique 57, une phase 58 d'évaluation de performances utilise avantageusement les étapes E1 à E5. Si aucun intervalle temporel de commutation édité en étape E5 ne dépasse un cycle d'horloge, on est assuré que le circuit tient les objectifs de performance en rapidité qu'on s'est fixé. Dans le cas contraire, on utilise les résultats de l'étape E5 pour redimensionner le circuit dans une phase 60.

A partir de la liste de connectique 57, une phase 59 d'évaluation d'immunité utilise avantageusement les étapes E6 à E13. L'évaluation d'immunité consiste à déterminer le ou les noeuds récepteurs du circuits dont l'immunité est trop faible pour résister aux bruits de diaphonie. A chacun de ces noeuds est associé le conducteur amené en amont sur son entrée. Si aucun noeud édité en étape E13 ne contient de noeuds inaptes à résister aux bruits de diaphonie, on est assuré que le circuit ne propage pas de bruits de diaphonie. Dans le cas contraire, on utilise les résultats de l'étape E13 pour redimensionner le circuit dans une phase 60. La phase 58 peut précéder la phase 59, de façon à bénéficier des instants de commutation générés en étape E2.

Si les phases 58 et ou 59 ne donnent pas de résultats satisfaisants quant à l'aptitude du circuit à fonctionner suffisamment rapidement et ou sans propager de bruits de diaphonie, une phase 60 de dimensionnement prévoit les actions correctrices suivantes. Pour chaque composant incriminé, conducteur ou noeud, une ou plusieurs des actions suivantes sont proposées. Une première action consiste à dimensionner le conducteur de façon à diminuer sa résistance. Ceci présente deux avantages. Le premier avantage est celui de diminuer sa constante de temps. Le second avantage est celui d'augmenter son aptitude à fournir un courant pour annuler des charges parasites provoquées par d'éventuels bruits de diaphonie.

Une deuxième action consiste à modifier le tracé du circuit de façon à diminuer les capacités de couplage avec d'autres conducteurs du circuit. Ceci présente deux avantages. Le premier avantage est celui de diminuer sa constante de temps. Le second avantage est celui de diminuer les causes de bruit d'origine diaphonique.

Une troisième action consiste à dimensionner le noeud récepteur branché en aval du conducteur de façon à augmenter son immunité Im.

Une quatrième action consiste à dimensionner le noeud émetteur branché en amont du conducteur de façon à augmenter sa puissance.

Suite à la phase 60, une phase 61 de production génère de nouveaux masques 55 qui incorporent tout dimensionnement effectué en phase 60. Il est possible de réitérer tout ou partie des phases 56 à 61 sur les nouveaux masques ainsi générés jusqu'à ce que la phase 60 devienne inutile. Les derniers masques générés en phase 61 permettent de réaliser des circuits rapides à très haute intégration.

## Revendications

**1.** Procédé d'évaluation d'aptitude d'un circuit à très haute intégration à résister aux bruits de diaphonie, caractérisé en ce qu'il comprend :

- une étape (E6) de recherche d'une tranche de temps de cycle d'horloge pour chaque conducteur ($L_e$) du circuit, dans laquelle un plus grand nombre d'intervalles temporels de commutation ($[t_{id}, t_{if}]$) se produisent sur des conducteurs ($L_i$) ayant une capacité de couplage ($C_{ei}$) avec le conducteur ($L_e$) considéré ; et
- une étape (E9) de détermination d'aptitude d'un récepteur (44), branché en aval du conducteur ($L_e$), à résister au bruit de diaphonie (Bu) provoqué par les conducteurs ($L_i$) sur le conducteur ($L_e$) considéré dans ladite tranche de temps.

2. Procédé selon la revendication 1, caractérisé en ce que la largeur de la tranche de temps est inversement proportionnelle à une fonction (f(Pam,RL)) du conducteur ($L_e$) considéré à contrer une apparition de bruit.

3. Procédé selon la revendication 1 ou 2, caractérisé en ce que le récepteur (44) est celui de plusieurs récepteurs (42,43,44) ayant une plus faible immunité (Im).

4. Procédé selon l'une des revendications 1 à 3, caractérisé en ce qu'il comprend une étape (E7) de mesure du bruit (Bu) proportionnellement à un rapport de la somme des capacités de couplage ($C_{ei}$) des conducteurs ($L_i$) ayant un intervalle de commutation ($[t_{id}, t_{if}]$) dans ladite tranche de temps, sur la somme de toutes les capacités de couplage existantes ($C_{ej}$) avec des conducteurs ($L_j$) du circuit.

5. Procédé de réalisation d'un circuit électrique ($L_e$), incluant une phase (61) de production de masques (55) et caractérisé en ce qu'il comprend :

- une phase d'évaluation (59) des composants des masques, dans laquelle est mis en oeuvre le procédé suivant l'une des revendications 1 à 4 ;
- une phase de dimensionnement (60) pour dimensionner tout ou partie des composants incriminés dans la phase d'évaluation (59) ; et
- une réitération de la phase (61) avec les composants dimensionnés en phase (60).

Figure 1a

Figure 1b

Fig.2

Fig.3

Fig.4

Fig.5

Fig. 6

$E_0$ — Extraction des paramètres physiques du circuit

$E_3$ — Génération de coefficients de pondération

$E_1$ — Génération de capacités équivalentes pour chaque conducteur

$E_2$ — Génération d'instants de commutation

$E_4$ — Test de fin

$E_4$ — Edition des résultats

Fig. 7

Fig.8

Fig.9

$E_5$ — Premier conducteur

$E_6$ — Pour le conducteur recherche d'une tranche de temps

$E_7$ — Mesure de Bu

$E_8$ — Mesure d'immunité de récepteur

$E_9$ — Aptitude du récepteur à résister au bruit

$E_{10}$ — Dernier conducteur?

oui    non

Edition des résultats — $E_{12}$

$E_{11}$ — Conducteur suivant

Fig. 10

60

Dimensionnement

59

Evaluation
d'immunité

61

58

Production

Evaluation de
performances

57

Netlist

56

Extraction

55

Masques

**Office européen des brevets**

**RAPPORT DE RECHERCHE EUROPEENNE**

Numéro de la demande

EP 01 10 9830

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| Y | US 5 481 695 A (PURKS STEPHEN R) 2 janvier 1996 (1996-01-02) * le document en entier * --- | 1-5 | G06F17/50 |
| Y | US 5 568 395 A (HUANG TAMMY) 22 octobre 1996 (1996-10-22) * colonne 1, ligne 35 - colonne 2, ligne 35 * * colonne 7, ligne 7 - ligne 23 * * colonne 11, ligne 7 - ligne 65 * * colonne 14, ligne 35 - ligne 51 * * colonne 16, ligne 33 - colonne 17; figures 1,2,13; tableau 2 * --- | 1-4 | |
| Y | US 5 555 506 A (PETSCHAUER RICHARD J ET AL) 10 septembre 1996 (1996-09-10) * colonne 1, ligne 42 - colonne 2, ligne 1 * * colonne 2, ligne 58 - colonne 3, ligne 63 * --- | 1-5 | |
| A | US 5 502 644 A (HAMILTON ERIC A ET AL) 26 mars 1996 (1996-03-26) * colonne 2, ligne 10 - ligne 30 * ----- | 1-4 | DOMAINES TECHNIQUES RECHERCHES (Int.Cl.7) G06F |

Le présent rapport a été établi pour toutes les revendications

| Lieu de la recherche | Date d'achèvement de la recherche | Examinateur |
|---|---|---|
| LA HAYE | 5 juillet 2001 | Guingale, A |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 01 10 9830

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

05-07-2001

| Document brevet cité au rapport de recherche | Date de publication | Membre(s) de la famille de brevet(s) | Date de publication |
|---|---|---|---|
| US 5481695 A | 02-01-1996 | AUCUN | |
| US 5568395 A | 22-10-1996 | AUCUN | |
| US 5555506 A | 10-09-1996 | AUCUN | |
| US 5502644 A | 26-03-1996 | AUCUN | |

EPO FORM P0460

Pour tout renseignement concernant cette annexe : voir Journal Officiel de l'Office européen des brevets, No. 12/82